# EUROPÄISCHE PATENTSCHRIFT

(11) **EP 0 977 041 B1**
(45) Veröffentlichungstag und Bekanntmachung des Hinweises auf die Patenterteilung: **05.10.2005**
(21) Anmeldenummer: 99250210.4
(22) Anmeldetag: 25.06.1999
(51) Int. Cl.: G01R 15/18, G01R 1/20

(54) **Wandlereinrichtungen für Schutzgeräte und Leistungsschaltereinrichtungen**
Transducer arrangement for protection apparatus and power breakers
Ensemble transducteur pour appareils de protection et disjoncteurs

(30) Priorität: 30.07.1998 DE 19836082
(43) Veröffentlichungstag der Anmeldung: 02.02.2000
(73) Patentinhaber: SIEMENS AKTIENGESELLSCHAFT, 80333 München (DE)
(72) Erfinder: Volkmar, Ralf Reiner, 23758 Oldenburg (DE); Ermisch, Jochen, 01445 Radebeul (DE)

(56) Entgegenhaltungen:
- DE-A- 2 650 633
- US-A- 4 550 360
- US-A- 5 206 623

## Beschreibung

Die Erfindung betrifft Wandlereinrichtungen für Schutzgeräte und Leistungsschaltereinrichtungen, insbesondere für Vakuum-leistungsschalter von Mittelspannungsschaltanlagen, die sekundärseitig jeweils mit einem Meßwiderstand abgeschlossen sind, wobei deren jeweiliger nicht zulässiger Spannungswert beim Stromwandler bzw. nicht zulässiger Spannungswert beim Spannungswandler zur Auslöseansteuerung des jeweiligen Schutzgerätes führt.
Strom- und Spannungswandler für den eingangs definierten Verwendungszweck sind u. a. aus EP 0 504 674 A2 bekannt. Die primär- oder sekundärseitigen Widerstände sind hier zur Verminderung der Streuinduktivität in segmentierte Wicklungen unterteilt, wobei die Teilwicklungen bei den Stromwandlern jeweils durch einen dem Teilungsverhältnis entsprechenden Teilbürdenwiderstand abgeschlossen sind. Bei den Wandlereinrichtungen sind die Teilwicklungen und deren Teilbürdenwiderstände zur Sicherstellung einer hohen Meßgenauigkeit sehr genau aufeinander abzustimmen.

Die US 4,550,360 offenbart eine Wandlereinrichtung mit Stromwandlern, die sekundärseitig mit Gleichrichtern verbunden sind. Die von dem Gleichrichter erzeugte Gleichspannung fällt an einer Bürde ab und wird anschließend einer Elektronik zugeführt, die einen Analog-Digitalwandler aufweist.

Beim Einsatz konventioneller Meßwandler mit konventionellen Schutzrelais hängt die Genauigkeit des Gesamtsystems im wesentlichen von drei Größen ab:
a) von der Genauigkeit der konventionellen Wandlereinrichtungen,
b) von der Genauigkeit der Bürdenwiderstände in den Schutzrelais als Bestandteil der nichtkonventionellen, leistungsarmen Wandlereinrichtungen, und
c) von der Genauigkeit der Meßwertverarbeitung, beispielsweise vom Spannungsabfall am Bürdenwiderstand im Schutzrelais durch deren Elektronik.

Die der Erfindung zugrunde liegende Aufgage besteht darin, den Gesamtaufwand zur Realisierung kostengünstiger Wandlereinrichtungen erheblich zu reduzieren, ohne jedoch die Anforderungen an die Meßgenauigkeiten in dieser Sicherheitstechnik einzuschränken.
Erfindungsgemäß wird dies durch die Kombination der Merkmale
1.1. die Wandlereinrichtungen sind durch Stromwandler bzw. durch Spannungswandler realisiert,
1.2. den Meßwiderständen der Stromwandlers bzw. den Meßwiderständen der Spannungswandler sind jeweils aus Widerstandsnetzwerken und aus Abgleichfeldern gebildete Abgleichmodule parallel geschaltet,
1.3. die Meßwiderstände und die Widerstandsnetzwerke sind jeweils auf gemeinsamen Leiterplatten positioniert,
1.4. die Leiterplatten sind derart im Bereich von Bohrlöchern mit durchkontaktierten abtragbaren Doppel-Leiterbahnen versehen, daß bei einem Bohrloch (BL) Abgleich im Bereich eines Bohrloches ein diesem durch gezielt gerichteten mechanischen Abtrag der Doppel-Leiterbahnen (LD) durchgeführten zugeordneter Teilwiderstand einem Festwiderstand des Widerstandsnetzwerkes zugeschaltet ist,
erreicht.

Beim Einsatz nichtkonventiöneller Strom - und Spannungswandler sind die Bürden integraler Bestandteil der Wandlereinrichtungen, bei der sich die auszuwertende Meßgröße, beispielsweise als Spannungsabfall, direkt am internen Bürdenwiderstand einstellt. Durch das Parallelschalten von Widerstandsnetzwerken mit entsprechenden Abgleichmodulen zu den Meßwiderständen ist erreicht, daß sowohl die Meßwandlerein-richtungen als auch die Bürdenwiderstände nicht als Präzisonswiderstände mit hoher Genauigkeit ausgeführt sein müssen, da die Meßwiderstände und die Widerstandsnetzwerke zusammen auf gemeinsamen Leiterplatten angeordnet sind und somit die jeweiligen Bürdenwiderstände in einfacher Weise durch die Widerstandsnetzwerke als sehr genaue Meßwiderstände abzugleichen sind.

Gemäß einer vorteilhaften Ausgestaltung der Erfindung ist das Merkmal
2.1 die Meßwiderstände sind jeweils integraler Bestandteil der Stromwandler bzw. der Spannungswandler,
vorgesehen.
Damit ist erreicht, daß der Abgleich des Gesamtsystems direkt innerhalb der jeweiligen Meßwandlereinrichtung erfolgen kann.

Eine weitere vorteilhaft Ausgestaltung sieht das Merkmal
3.1 die Meßwiderstände sind jeweils durch Unterspannungswiderstände der Spannungswandler realisiert,
vor.
Bei diese Ausgestaltung kann auf die sonst üblichen zusätzlichen Meßwiderstände verzichtet werden.

Gemäß einer weiteren vorteilhaften Ausgestaltung der Erfindung sind die Merkmale
4.1. die Meßwiderstände enthalten Bürdenwiderstände mit auf stabförmigen Isolierkörpern umfangsseitig angeordneten, linienförmigen Teilwiderstands-Leiterbahnen,
4.2. die Teilwiderstands-Leiterbahnen sind durch widerstandswertigkeitsbestimmende Verbindungsstege miteinander verbunden,
4.3. die Verbindungsstege der Teilwiderstands-Leiterbahnen sind jeweils als Abgleichanschlüsse herausgeführt,
vorgesehen.
In dieser Ausgestaltung sind die Bürdenwiderstände aus linienförmigen Teilwiderstands - Leiterbahnen gebildet, die auf Isolierkörper mit beispielsweise runden, ovalen oder sonstige Querschnittsformen mit möglichst stark abgerundeten Kanten aufgebracht sind. Diese Bürdenwiderstände lassen sich besonders vorteilhaft auch in Komponenten von Mittelspannungs-Schaltanlagen unterbringen.

Die Erfindung wird durch 5 Figuren näher erläutert, wobei die
- Figuren 1 und 2: jeweils einen nichtkonventionellen, leistungsarmen Strom- und Spannungswandler abbilden, die
- Figur 3: in der Seitenansicht und der Draufsicht besonders die Anordnung von Meßwiderstand und Widerstandsnetzwerk auf einer gemeinsamen Leiterplatte zeigt, die
- Figur 4: den schrittweisen Abgleich durch Auftrennen der Leiterbahn im Bereich eines Bohrloches der Leiterplatten erkennen läßt und die
- Figur 5: eine mögliche Ausführung eines Bürdenwiderstand auf einem stabförmigen Isolierkörper zeigt.

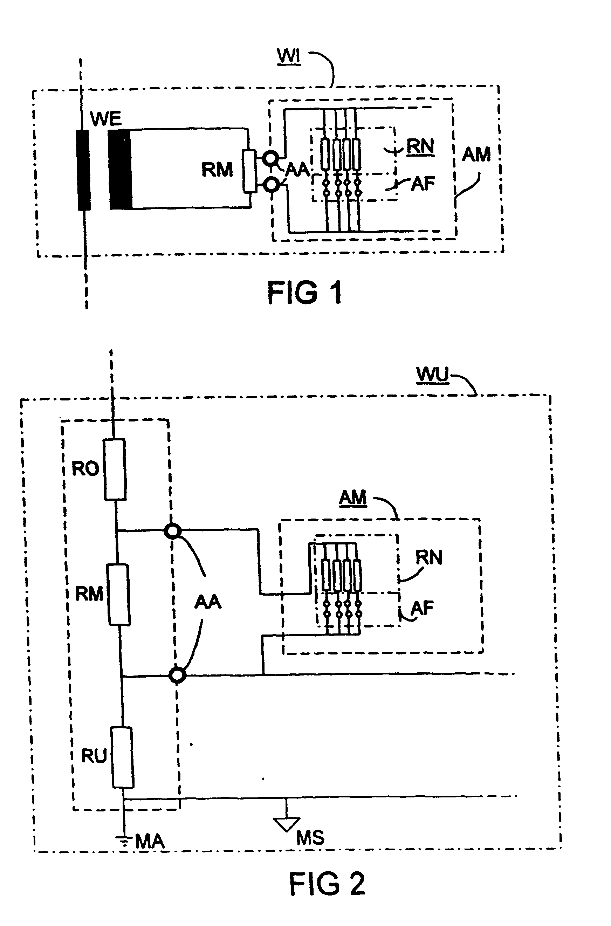

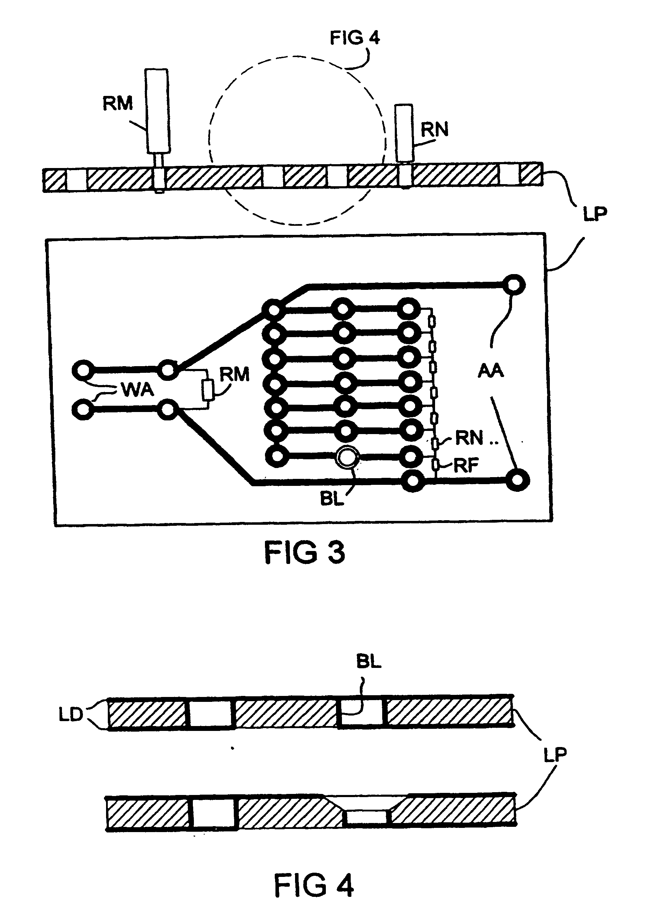

Die Figur 1 bildet den Stromwandler WI ab, dessen sekundärseitige Wandlereinrichtung WE mit dem Meßwiderstand RM abgeschlossen ist. Der Meßwiderstand RM weist die Abgleichanschlüsse AA auf, mit denen ein Abgleichmodul AM, bestehend aus dem Widerstandsnetzwerk RN mit einer Vielzahl nicht bezeichneter Teilwiderstände und dem Abgleichfeld AF, direkt elektrisch leitend verbunden ist. Die Teilwiderstände des Widerstandsnetzwerks RN können dem Meßwiderstand RM, wie der Beschreibung zu Figur 3 zu entnehmen ist, bedarfsweise hinzugefügt bzw. von diesem entfernt werden.

Der Figur 2 ist ein Spannungsteiler WU zu entnehmen, der im wesentlichen aus dem Oberspannungswiderstand RO, dem Meßwiderstand RM und dem Unterspannungswiderstand RU gebildet ist. Auch hier ist der Meßwiderstand RM über die Abgleichanschlüsse AA herausgeführt, um in gleicher Weise, wie der vorab in Figur 1 beschriebene Strommandler, mit dem Abgleichmodul AM verbunden werden zu können. Gleichzeitig ist hier noch angedeutet, daß das freie Ende des Unterspannungswiderstandes RU mit dem Potential einer Anlagenmasse MA und/oder mit dem Potential einer Signalmasse MS verbunden sein kann.

Der Figur 3 ist insbesondere zu entnehmen, daß der Meßwiderstand RM und das Widerstandsnetzwerk RN auf der gemeinsamen Leiterplatte LP angeordnet sind. Auf der Leiterplatte LP sind neben den Wandleranschlüssen WA und den Abgleichanschlüssen AA außer dem Festwiderstand RF zusätzlich diverse nicht bezeichnete Teilwiderstände des Widerstandsnetzwerks RN angeordnet.

Des weiteren geht insbesondere aus der Figur 4 hervor, daß die Leiterplatte LP im Bereich der unterbrochenen Linienzüge der Figur 3 mindestens teilweise mit sogenannten Doppel-Leiterbahnen LD zwischen den Bohrlöchern BL ausgestattet ist. Durch gezielt gerichteten mechanischen Abtrag der Doppel-Leiterbahnen LD, der beispielsweise durch einen Bohrvorgang vorgenommen werden kann, lassen sich somit zu dem Festwidertand RF zusätzlich die nicht bezeichneten Teilwiderstände des Widerstandsnetzwerks RN durch gezieltes Aufbohren der Bohrlöcher BL einzeln hinzufügen. Durch diese Maßnahme des gezielten Abgleichs können sowohl der Meßwiderstand RM als auch die Teilwiderstände des Widerstandsnetzwerks RN ohne Einschränkungen hinsichtlich der Meßgenauigkeit mit handelsüblichen Toleranzwerten eingesetzt werden.

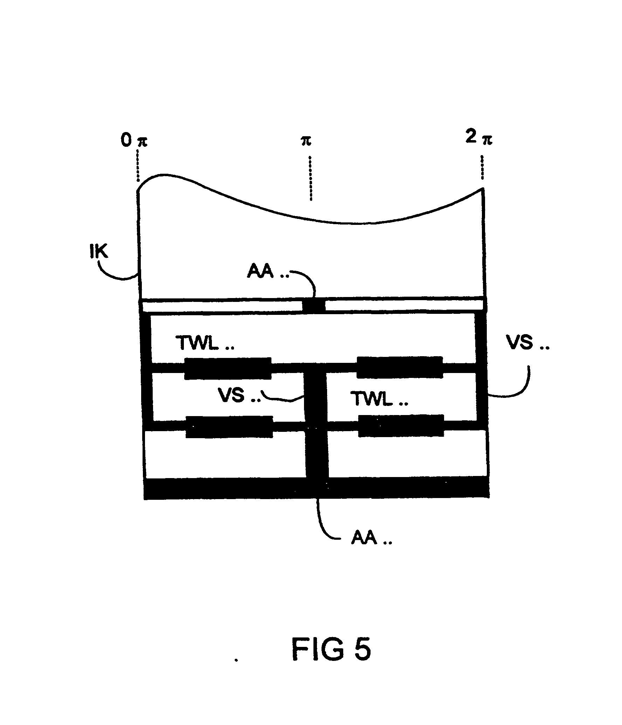

Die Figur 5 zeigt Teile einer Wandlereinrichtung, bei der die Meßwiderstände RM als Bürde mit auf stabförmigen Isolierkörpern IK aufgebrachten, linienförmigen Teilwiderstands-Leiterbahnen TWL.. ausgeführt sind. Dabei sind die Teilwiderstands-Leiterbahnen TWL mit Verbindungsstegen VS .. verbunden und die Abgleichanschlüsse AA.. von außen her zugänglich. Zu besseren Verständnis sind die Teilwiderstands-Leiterbahnen TWL.. und die Verbindungsstege VS.. sowie die Abgleichanschlüsse AA auf der abgewickelten Umfangsfläche des Isolierkörpers dargestellt.
Derartig ausgeführte Teile von Wandlereinrichtungen, also Bürdenwiderstände mit runder, ovaler oder beliebiger Querschnittskontur, lassen sich sowohl direkt in Schaltanlagen, vorzugsweise in Mittelspannungs-Schaltanlagen, einsetzen, als auch in einfacher Weise in Komponenten dieser Anlagen unterbringen.
Die Wandlereinrichtungen für Schutzgeräte und Leistungsschaltereinrichtungen sowie für deren Komponenten sind gegenüber den bisher bekannten Ausführungen, insbesondere auch im Hinblick auf den Einsatz einfacherer Widerstandsbauelemente, mit geringerem Einbauvolumen herstellbar, so daß sich in Einzelfällen auch geringere Einbautiefen für die Schaltanlagen und/oder deren Komponenten ergeben.

## Patentansprüche

1. Wandlereinrichtungen für Schutzgeräte und Leistungsschaltereinrichtungen, insbesondere für Vakuum-Leistungsschalter von Mittelspannungs-Schaltanlagen, die sekundärseitig jeweils mit einem Meßwiderstand abgeschlossen sind, wobei deren jeweiliger nicht zulässiger Spannungswert beim Stromwandler bzw. nicht zulässiger Spannungswert beim Spannungswandler zur Auslöseansteuerung des jeweiligen Schutzgerätes führt, mit den Merkmalen
1.1. die Wandlereinrichtungen sind durch Stromwandler (WI) bzw. durch Spannungswandler (WU) realisiert, ferner **gekennzeichnet durch** die Merkmale
1.2. den Meßwiderständen (RM) der Stromwandler (WI) bzw. den Meßwiderständen (RM) der Spannungswandler (WU) sind jeweils aus Widerstandsnetzwerken (RN) und aus Abgleichfeldern (AF) gebildete Abgleichmodule (AM) parallel geschaltet,
1.3. die Meßwiderstände (RM) und die Widerstandsnetzwerke (RN) sind jeweils auf gemeinsamen Leiterplatten (LP) positioniert,
1.4. die Leiterplatten (LP) sind derart im Bereich von Bohrlöchern (BL) mit durchkontaktierten abtragbaren Doppel-Leiterbahnen (LD) versehen, daß bei einem Bohrloch (BL) Abgleich im Bereich eines Bohrloches (BL) ein diesem **durch** gezielt gerichteten mechanischen Abtrag der Doppel-Leiterbahnen (LD) durchgeführten zugeordneter Teilwiderstand einem Festwiderstand (RF) des Widerstandsnetzwerkes (RN) zugeschaltet ist.

2. Wandlereinrichtungen nach Patentanspruch 1,
**gekennzeichnet durch** das Merkmal
2.1. die Meßwiderstände (RM) sind jeweils integraler Bestandteil der Stromwandler (WI) bzw. der Spannungswandler (WU).

3. Wandlereinrichtungen nach Patentanspruch 1,
**gekennzeichnet durch** das Merkmal
3.1. die Meßwiderstände (RM) sind jeweils **durch** Unterspannungswiderstände (RU) der Spannungswandler (WU) realisiert.

4. Wandlereinrichtungen nach Patentanspruch 1,
**gekennzeichnet durch** die Merkmale
4.1. die Meßwiderstände (RM) enthalten Bürdenwiderstände mit auf stabförmigen Isolierkörpern (IK) umfangsseitig angeordneten, linienförmigen Teilwiderstands-Leiterbahnen (TWL..),
4.2. die Teilwiderstands-Leiterbahnen (TWL..) sind **durch** widerstandswertigkeitsbestimmende Verbindungsstege (VS..) miteinander verbunden,
4.3. die Verbindungsstege (VS..) der Teilwiderstands-Leiterbahnen (TWL..) sind jeweils als Abgleichanschlüsse (AA) herausgeführt.

## Claims

1. Transformer devices for protective devices and circuit breaker devices, in particular for vacuum circuit breakers in medium-voltage switchgear assemblies, which are terminated in each case on the secondary side by a measuring resistor, the respective impermissible voltage value, in the case of a current transformer, or impermissible voltage value, in the case of a voltage transformer, of said transformer devices leading to triggering of the respective protective device, having the following features
1.1. the transformer devices are realized by current transformers (WI) or by voltage transformers (WU), further **characterized by** the following features
1.2. compensating modules (AM), which are in each case formed from resistor networks (RN) and compensating fields (AF), are connected in parallel with the measuring resistors (RM) of the current transformers (WI) or the measuring resistors (RM) of the voltage transformers (WU),
1.3. the measuring resistors (RM) and the resistor networks (RN) are in each case positioned on common printed circuit boards (LP),
1.4. the printed circuit boards (LP) are provided with through-plated twin conductor tracks (LD), which can be removed, in the region of drilled holes (BL) such that, during compensation, which is carried out by means of mechanically removing the twin conductor tracks (LD) in a targeted manner, a resistor element, which is associated with a drilled hole (BL), is connected to a fixed resistor (RF) of the resistor network (RN) in the region of said drilled hole (BL).

2. Transformer devices according to Patent Claim 1,
**characterized by** the following feature
2.1. the measuring resistors (RM) are in each case an integral part of the current transformers (WI) or the voltage transformers (WU).

3. Transformer devices according to Patent Claim 1, **characterized by** the following feature
3.1. the measuring resistors (RM) are in each case realized by low-voltage resistors (RU) of the voltage transformers (WU).

4. Transformer devices according to Patent Claim 1, **characterized by** the following features
4.1. the measuring resistors (RM) contain load resistors having linear resistor element conductor tracks (TWL..) which are arranged around the circumference of rod-shaped insulating bodies (IK),
4.2. the resistor element conductor tracks (TWL..) are connected to one another by means of connecting webs (VS..) determining the resistance value,
4.3. the connecting webs (VS..) of the resistor element conductor tracks (TWL..) are in each case in the form of compensating connections (AA).

## Revendications

1. Ensembles transducteurs pour des appareils de protection et des disjoncteurs, notamment pour des disjoncteurs sous vide d'installations de distribution en moyenne tension, qui sont terminés du côté secondaire respectivement par une résistance de mesure, leur valeur respective de tension inadmissible pour le transducteur de courant ou leur valeur de tension inadmissible pour le transducteur de tension provoquant la commande de déclenchement de l'appareil respectif de protection comprenant les caractéristiques
1.1. les ensembles transducteurs sont réalisés par un transducteur (WI) de courant ou par un transducteur (WU) de tension, **caractérisés en outre par** les caractéristiques
1.2. des modules (AM) d'équilibrage, formés respectivement de réseaux (RN) de résistances et de champs (AF) d'égalisation, sont montés en parallèle avec les résistances (RM) de mesure du transducteur (WI) de courant ou avec les résistances (RM) de mesure du transducteur (WU) de tension,
1.3. les résistances (RM) de mesure et les réseaux (RN) de résistances sont mis respectivement sur des plaquettes (LP) à circuit imprimé communes,
1.4. les plaquettes (LP) à circuit imprimé sont munies, dans la zone de trous (BL) perforés, de doubles pistes (LD) conductrices traversantes et pouvant être enlevées, de sorte que, par une égalisation effectuée par un enlèvement de matière mécanique dirigé de façon ciblée des doubles pistes (LD) conductrices dans la région d'un trou (BL) perforé, une sous-résistance associée à ce trou est ajoutée à une résistance (RF) fixe du réseau de résistances.

2. Ensembles transducteurs suivant la revendication 1, **caractérisés par** les caractéristiques
2.1. les résistances (RM) de mesure font respectivement partie intégrante du transducteur (WI) de courant ou du transducteur (WU) de tension.

3. Ensembles transducteurs suivant la revendication 1, **caractérisés par** les caractéristiques
3.1. les résistances (RM) de mesure sont réalisées respectivement par des résistances (RU) de basse tension du transducteur (WU) de tension.

4. Ensembles transducteurs suivant la revendication 1, **caractérisés par** les caractéristiques
4.1. les résistances (RM) de mesure contiennent des résistances de charge ayant des pistes (TWL...) conductrices de sous-résistances linéaires disposées du côté périphérique sur des corps (IK) isolants en forme de barres,
4.2. les pistes (TWL...) conductrices de sous-résistances sont reliées entre elles par des barrettes (VS...) de liaison déterminant la valeur de la résistance,
4.3. les barrettes (VS...) de liaison des pistes (TWL...) conductrices de sous-résistances sont sorties respectivement sous forme de bornes (AA) d'équilibrage.
